# EUROPÄISCHE PATENTSCHRIFT

(11) **EP 4 417 022 B1**
(45) Veröffentlichungstag und Bekanntmachung des Hinweises auf die Patenterteilung: **24.09.2025**
(21) Anmeldenummer: 22793662.2
(22) Anmeldetag: 12.10.2022
(51) Int. Cl.: H05K 7/14, H05K 7/20

(54) **RECHENZENTRUM MIT EINER IN EINEM CONTAINER ANGEORDNETEN SCHALTSCHRANKREIHE UND EINER KALTGANG-WARMGANG-SCHOTTUNG**
DATA CENTER WITH A ROW OF SWITCH CABINETS ARRANGED IN A CONTAINER AND A COLD-AISLE-HOT-AISLE SEPARATOR
CENTRE DE DONNÉES AVEC UNE RANGÉE D'ARMOIRES DE COMMUTATION DISPOSÉES DANS UN CONTENEUR ET UN SÉPARATEUR ALLÉE FROIDE-ALLÉE CHAUDE

(30) Priorität: 13.10.2021 DE 102021126550
(43) Veröffentlichungstag der Anmeldung: 21.08.2024
(73) Patentinhaber: Rittal GmbH & Co. KG, 35745 Herborn (DE)
(72) Erfinder: MESCHKAT, Jan, 35625 Hüttenberg (DE); STURM, Peter, 35638 Leun (DE); SCHACHT, Jan-Eric, 57290 Neunkirchen (DE)
(74) Vertreter: Angerhausen, Christoph
(86) Internationale Anmeldenummer: PCT/DE2022/100755
(87) Internationale Veröffentlichungsnummer: WO 2023/061536

(56) Entgegenhaltungen:
- EP-A1- 2 803 813
- EP-A1- 2 811 366
- EP-A2- 3 843 511
- WO-A1-2015/186343
- WO-A1-2020/219082
- JP-A- 2001 148 590
- JP-B2- 5 945 716
- US-A1- 2014 273 792
- US-B1- 10 925 185
- US-B1- 11 039 551

## Beschreibung

Die Erfindung geht aus von einem Rechenzentrum mit einer in einem Container angeordneten Schaltschrankreihe, die mit einer Schottung einen Kaltgang von einem Warmgang trennt, und wird durch die beigefügten Ansprüche definiert. Ein derartiges Rechenzentrum ist in der EP 3 157 316 B1 beschrieben. Ähnliche Rechenzentren beschreiben auch die WO 2014/174606 A1, die US 2013/0008197 A1 und die US 2015/0245541 A1.

Die WO 2020/219082 A1 beschreibt ein solches Rechenzentrum, bei dem mindestens ein Kühlgerät in mindestens einen Durchbruch durch eine Außenwand des Containers eingesetzt ist, das mit seinem Luftinnenkreis mit dem Innern des Containers verbunden ist, und das mit seinem von dem Luftinnenkreis fluidisch abgeschlossenen Luftaußenkreis mit der Umgebung des Containers verbunden ist, und wobei die Schottung einen Kühlluftausgang des Luftinnenkreises von einem Warmlufteingang des Luftinnenkreises fluidisch trennt. Ähnliche Rechenzentren sind auch aus der US 11 039 551 B1, der WO 2015/186343 A1, der US 10 925 185 B1, der US 2014/273792 A1 und der EP 2 811 366 A1 bekannt.

Die bekannten Rechenzentren, welche auf einem Container basieren, haben den Nachteil, dass sie nur eine eingeschränkte Skalierbarkeit der zur Verfügung gestellten Kühlleistung aufweisen. Insbesondere sind entsprechende Kühlgeräte in der Regel fest im Container verbaut, sodass für eine Aufstockung der Kühlleistung etwa im Rahmen einer Erweiterung der IT-Infrastruktur im Container, beispielsweise ein Inline-Kühlgerät in der Schaltschrankreihe gegen ein anderes Kühlgerät entsprechend angepasster Kühlkapazität ausgetauscht werden muss. Auch sind die Kühlgeräte hinsichtlich der verwandten Kühltechnologie limitiert oder bedürfen einer erheblichen Verrohrung um externe Freikühler oder Chiller mit in der Schaltschrankreihe oder im Doppelboden verbauten Verdampfern fluidisch zu verbinden.

Es ist daher die Aufgabe der Erfindung, ein Rechenzentrum der eingangs beschriebenen Art derart weiterzuentwickeln, dass es hinsichtlich der verwandten Kühltechnologie eine hohe Skalierbarkeit aufweist und dazu insbesondere der Austausch der Kühltechnologie, etwa zur Kapazitätsanpassung, mit einfachen technischen Mitteln realisiert ist.

Diese Aufgabe wird durch ein Rechenzentrum mit den Merkmalen des Hauptanspruchs gelöst. Die abhängigen Ansprüche betreffen jeweils vorteilhafte Ausführungsformen der Erfindung.

Demgemäß ist bei einem Rechenzentrum vorgesehen, dass das mindestens eine Kühlgerät in mindestens einem Durchbruch durch eine vertikale Außenwand des Containers eingesetzt ist.

Die Erfindung macht sich somit den Umstand zu Nutze, dass Container bauartbedingt in annähernd beliebiger Weise mit Durchbrüchen versehen werden können, auch nachträglich, um darin Kühlgeräte beliebiger Kapazität einfach austauschbar einzusetzen. Die Kühlgeräte wiederrum können aus dem Stand der Technik bekannte Schaltschrankkühlgeräte sein, die entsprechend in oder an einem Durchbruch eines Flachteils eines Schaltschrankgehäuses montiert werden können, sodass sie mit ihrem Luftinnenkreis dem Schaltschrankinnern und mit ihrem Luftaußenkreis der Umgebung des Schaltschrankgehäuses zugeordnet sind. In dem Kühlgerät können bauartabhängig verschiedene Kühltechnologien realisiert sein, beispielsweise eine Freikühlung, eine Kältemaschine oder eine Kombination aus beiden. Ein für die vorliegende Erfindung besonders geeignetes Kühlgerät ist beispielsweise in der EP 2 891396 B1 beschrieben.

Der Kühlluftausgang kann unterhalb von dem Warmlufteingang angeordnet sein, wobei der Kühlluftausgang vorzugsweise vertikal unterhalb von dem Warmlufteingang angeordnet ist. Diese Anordnung von Kühlluftausgang und Warmlufteingang entspricht der bei Schaltschrankkühlgeräten üblichen Anordnung, die dazu eingerichtet ist, in einem unteren Bereich des Schaltschrankgehäuses Kühlluft einzublasen und diese nach Erwärmung und entsprechender Konvektion in einem oberen Bereich des Schaltschrankgehäuses wieder in das Kühlgerät anzusaugen. Bei einer Ausführungsform der Erfindung wird diese Anordnung von Warmlufteingang und Luftausgang ausgenutzt, um entsprechend in einem unteren Bereich die Schaltschrankreihe im Kaltgang mit Kühlluft zu beaufschlagen und in einem davon abgeschotteten oberen Bereich aus dem Warmgang erwärmte Luft abzusaugen.

Das Innere des Containers kann von der Umgebung des Containers fluidisch abgetrennt sein, sodass eine Durchmischung der im Innern des Containers aufgenommenen Luft und der Umgebungsluft vermieden ist. Abweichend von den aus dem Stand der Technik bekannten Containerlösungen ist es daher auch nicht erforderlich, dass eine Filterung der in das Schaltschrankinnere eintretenden Luft erfolgt, da keine eventuell mit Verunreinigungen belastete Umgebungsluft in den Container hineingefördert wird.

Die Schottung kann zumindest abschnittweise horizontal und/oder unter einem spitzen Winkel zur Horizontalen geführt sein. Die Schottung kann zumindest in einem horizontalen und/oder unter einem spitzen Winkel zur Horizontalen geführten Abschnitt optisch transparenten Abschnitt eine nach unten abstrahlende Lichtquelle angeordnet ist. Die Lichtquelle kann insbesondere unter der Decke des Containers angeordnet sein, wie dies bei Container-Rechenzentren aus dem Stand der Technik bekannt ist. Insofern beeinflusst die erfindungsgemäße Schottung des Rechenzentrums in keiner Weise die übliche lichttechnische Infrastruktur des Container-Rechenzentrums.

Der Warmgang kann sich oberhalb der Schaltschrankreihe über die gesamte Breite des Innern des Containers über die Schaltschrankreihe hinweg erstrecken. Insbesondere kann somit vorgesehen sein, dass die Schottung an keiner Stelle an die Decke des Containers angrenzt. Vielmehr kann die Schottung zwischen einer Oberseite der Schaltschrankreihe und derjenigen Außenwand, vorzugsweise einer vertikalen Seitenwand, des Containers geführt sein, in welcher der mindestens eine Durchbruch ausgebildet ist, in welchen das mindestens eine Kühlgerät eingesetzt ist, wobei die Schottung an ihrem Übergang zu der Außenwand dann in der erfindungsgemäßen Weise den dem Warmgang zugewandten Warmlufteingang von dem dem Kaltgang zugewandten Kühlluftausgang fluidisch abtrennt.

Der Warmgang kann sich dementsprechend zwischen gegenüberliegenden vertikalen Außenwänden des Containers erstrecken, wobei eine der Außenwände die Außenwand mit dem mindestens einen Durchbruch ist. Insbesondere kann sich der Warmgang zumindest abschnittsweise durchgängig zwischen gegenüberliegenden vertikalen Außenwänden des Containers erstrecken.

Der Kühlluftausgang kann unterhalb eines horizontalen oder sich unter einem spitzen Winkel zur Horizontalen erstreckenden Abschnitts der Schottung angeordnet sein.

Der Kühlluftausgang kann gegenüberliegend von einem Kühllufteingang der Schaltschrankreihe angeordnet sein. Dabei ist vorzugsweise ein Warmluftausgang der Schaltschrankreihe an einer in Bezug auf den Kühllufteingang der Schaltschrankreihe gegenüber angeordneten Seite der Schaltschrankreihe angeordnet.

In dem Warmgang kann oberhalb von der Schaltschrankreihe, vorzugsweise zwischen der Schaltschrankreihe und der Decke des Containers, eine horizontale Luftführung mit mindestens einem Luftführungskanal angeordnet sein, wobei der mindestens eine Luftführungskanal vorzugsweise in den Warmlufteingang des Luftinnenkreises des Kühlgerätes mündet.

Das Kühlgerät kann eine Freiluftkühlung aufweisen, die vorzugsweise ein Wärmerohr oder eine Heatpipe aufweist. Zusätzlich kann das Kühlgerät eine Kältemaschine aufweisen, wobei die Freiluftkühlung und die Kältemaschine voneinander getrennte Kältemittelkreisläufe aufweisen. Insbesondere können die beiden voneinander getrennten Kältemittelkreisläufe unabhängig voneinander betrieben werden, beispielsweise abhängig von der Temperaturdifferenz zwischen einer Ist-Temperatur im Schaltschrankinnern und einer Umgebungstemperatur des Containers und/oder abhängig von einer bereitzustellenden Kühlleistung.

Die beiden Kältemittelkreisläufe können unter Priorisierung der Freiluftkühlung und abhängig von einer Verlustleistung der Schaltschrankreihe sowie einer Umgebungslufttemperatur des Containers angesteuert sein, um eine erforderliche Kühlleistung bereitzustellen.

Mit Hilfe des Rechenzentrums der zuvor beschriebenen Art kann eine All-In-One-Containerlösung für den Außenbereich bereitgestellt werden, bei der aufgrund der sehr guten Verfügbarkeit beliebiger Schaltschrank-Kühlgeräte eine sehr hohe Energie- und Kosteneffizienz für den Betrieb des Rechenzentrums bereitgestellt werden kann. Aufgrund der guten Skalierbarkeit können Bereiche mit einer IT-Last von 10 bis 70 kW optimal abgedeckt werden. Insbesondere können im Vergleich zu den aus dem Stand der Technik bekannten Rechenzentren Splitgeräte, welche eine aufwändige Verrohrung aufweisen und nur bedingt an sich ändernde Kühlanforderungen adaptierbar sind, vermieden werden.

Weitere Einzelheiten der Erfindung werden anhand der nachstehenden Figuren erläutert. Dabei zeigt:
- Figur 1: in perspektivischer Darstellung eine Außenansicht eines erfindungsgemäßen Rechenzentrums; und
- Figur 2: eine Querschnittsansicht des Rechenzentrums gemäß Figur 1.

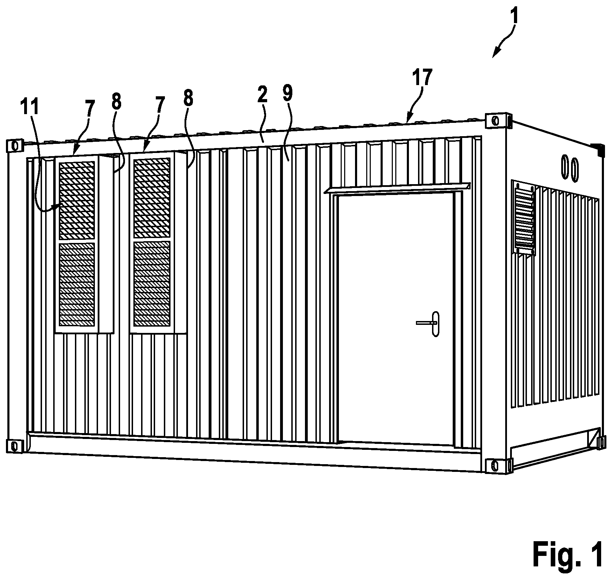

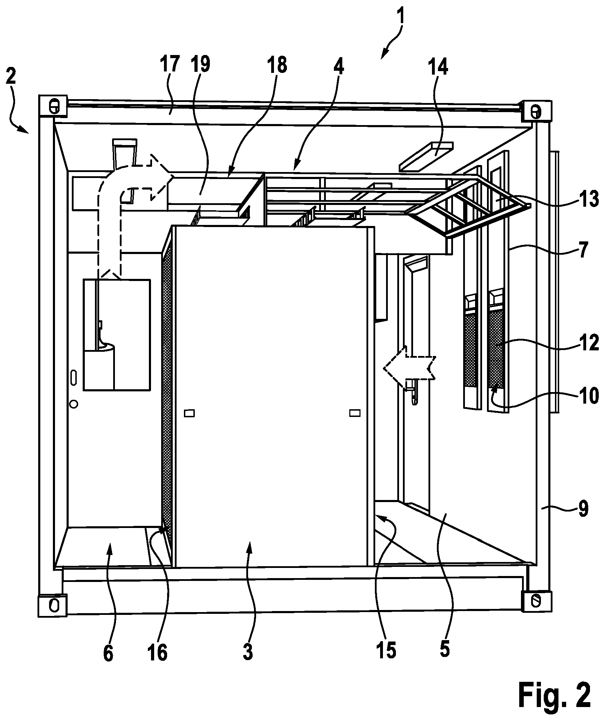

Die Figuren 1 und 2 zeigen eine beispielhafte Ausführungsform eines erfindungsgemäßen Rechenzentrums 1, welches auf einem Container 2 basiert. In eine vertikale Außenwand 9 sind vorliegend zwei Kühlgeräte 7 eingesetzt, wozu die Außenwand 9 zwei Ausbrüche 8 aufweist, durch welche sich jeweils ein Kühlgerät 7 hindurcherstreckt, sodass sie mit ihrem Luftinnenkreis 10 fluidisch in Verbindung mit dem Innern des Containers 2 stehen, während ihr Luftaußenkreis 11 zur Umgebung des Container 2 offen ist. Das Kühlgerät 7 kann beispielsweise ein Kühlgerät sein, wie es in der EP 2 891 396 B1 beschrieben ist, mit einem fluidisch vom Luftinnenkreis abgetrennten Luftaußenkreis und basierend auf einer hybriden Kühltechnologie, bestehend aus einer Kältemaschine und einer Heatpipe, welche voneinander getrennte Kältemittelkreisläufe aufweisen und unabhängig voneinander ansteuerbar sind, um situationsabhängig und beispielsweise nach Energieeffizienzerwägungen eine erforderliche Kühlleistung beispielsweise zur Kompensation einer aktuell vorhandenen Verlustleistung einer in der Schaltschrankreihe 3 aufgenommenen IT-Infrastruktur zu kompensieren.

Die Figur 1 veranschaulicht weiterhin, dass die Anzahl der Kühlgeräte 7 im Grunde beliebig skalierbar ist, indem bedarfsweise zusätzliche Durchbrüche 8 in die Außenwand 9 eingebracht werden. Da die Kühlgeräte 7 marktübliche Schaltschrankkühlgeräte sein können, können diese auch einzeln und bedarfsweise ausgetauscht werden, sodass eine hochflexible Anpassung der Kühltechnologie und der Kühlleistung sowie Effizienz der Kühlgeräte erreicht werden kann.

Die Figur 2 veranschaulicht, dass im Innern des Containers 2 in der an und für sich bekannten Weise eine Schaltschrankreihe 3 aufgenommen ist, welche einen Kaltgang 5 von einem Warmgang 6 trennt, wobei abweichend von den aus dem Stand der Technik bekannten Lösungen eine Schottung 4 gerade nicht zwischen der Oberseite der Schaltschrankreihe 3 und dem Dach 17 des Containers 2 geführt ist, sondern ausgehend von der Oberseite der Schaltschrankreihe 3 zu der Außenwand 9 des Containers 2, in welche die beiden Kühlgeräte 7 eingesetzt sind.

Die Schottung 4 grenzt dabei gerade derart an die Außenwand 9, dass ein Kühlluftausgang 12 des Luftinnenkreises 10 von einem Warmlufteingang 13 des Luftinnenkreises 10 fluidisch abgetrennt wird. Dazu kann insbesondere vorgesehen sein, dass sich in der grundsätzlich aus dem Stand der Technik bekannten Weise auch die erfindungsgemäße Schottung 4 über die gesamte Länge (senkrecht zur Zeichnungsebene der Figur 2) der Schaltschrankreihe 3 erstreckt. Die über den Kühlluftausgang 12 des Kühlgeräts 7 aus dem Innenkreis 10 austretende Kühlluft wird unmittelbar vor einen Kühllufteingang 15 der Schaltschrankreihe 3 geblasen. Die Kühlluft wird aufgrund des erzeugten Überdrucks im Kaltgang durch die Schaltschrankreihe 3 hindurchgedrückt, dabei erwärmt und als erwärmte Luft in den Warmgang 6 ausgeblasen. Abweichend von den aus dem Stand der Technik bekannten Rechenzentren kann die Warmluft nunmehr über die gesamte Breite des Containers, das heißt auch über den Kaltgang 5 hinweg bis zu der das Kühlgerät 7 aufweisenden Außenwand 9 gelangen, um von dort über den Warmlufteingang 13 des Luftinnenkreises 10 in das Kühlgerät 7 eingesogen zu werden. Nachdem die Warmluft in den Kühlgerät 7 abgekühlt worden ist, kann sie in der zuvor beschriebenen Weise wieder als gekühlte Luft in den Kaltgang 5 ausgeblasen werden und erneut die Schaltschrankreihe 3 beaufschlagen.

Die Schottung 4 ist zumindest abschnittsweise horizontal oder unter einem spitzen Winkel zu dem Dach 17 beziehungsweise zur Horizontalen geführt. Zumindest in dem horizontalen Abschnitt und/oder in einem unter einem spitzen Winkel zur Horizontalen beziehungsweise dem Dach 17 geführten Abschnitt kann die Schottung 4 optisch transparent ausgebildet sein, sodass sie lichtdurchlässig ist. Dies ermöglicht es, dass die Schottung 4 selbst keinerlei Lichtquellen aufweisen muss, sondern die standartmäßig in Containern für Rechenzentren an der Decke 17 vorgesehenen Lichtquellen **14** verwendet werden können, sodass insoweit keinerlei Anpassungen der Lichttechnik zur Verwendung der erfindungsgemäßen Schottung erforderlich sind.

Um die Luftführung oberhalb der Schaltschrankreihe 3 zu optimieren ist zwischen der Schaltschrankreihe 3 und der Decke 17 des Containers 2 eine horizontale Luftführung 18 mit einem Luftführungskanal 19 vorgesehen. Es kann vorgesehen sein, dass der Luftführungskanal in den Warmlufteingang des Luftinnenkreises des Kühlgeräts mündet, um die Luftführung von der den Warmluftausgang 16 der Schaltschrankreihe 3 aufweisenden Seite der Schaltschrankreihe 3 über die Schaltschrankreihe 3 hinweg bis zu dem Warmlufteingang 13 des Kühlgerätes 7 in der im Kaltgang 5 begrenzenden Außenwand 9 des Containers 2 zu optimieren.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Rechenzentrum
- 2: Container
- 3: Schaltschrankreihe
- 4: Schottung
- 5: Kaltgang
- 6: Warmgang
- 7: Kühlgerät
- 8: Durchbruch
- 9: Außenwand
- 10: Luftinnenkreis
- 11: Luftaußenkreis
- 12: Kühlluftausgang
- 13: Warmlufteingang
- 14: Lichtquelle
- 15: Kühllufteingang
- 16: Warmluftausgang
- 17: Decke
- 18: Luftführung
- 19: Luftführungskanal

## Patentansprüche

1. Rechenzentrum (1) mit einer in einem Container (2) angeordneten Schaltschrankreihe (3), die mit einer Schottung (4) einen Kaltgang (5) von einem Warmgang (6) trennt, wobei mindestens ein Kühlgerät (7) in mindestens einen Durchbruch (8) durch eine vertikale Außenwand (9) des Containers (2) eingesetzt ist, das mit seinem Luftinnenkreis (10) mit dem Innern des Containers (2) verbunden ist, und das mit seinem von dem Luftinnenkreis (10) fluidisch abgeschlossenen Luftaußenkreis (11) mit der Umgebung des Containers (2) verbunden ist, und wobei die Schottung (4) einen Kühlluftausgang (12) des Luftinnenkreises (10) von einem Warmlufteingang (13) des Luftinnenkreises (10) fluidisch trennt.

2. Rechenzentrum (1) nach Anspruch 1, bei dem der Kühlluftausgang (12) unterhalb von dem Warmlufteingang (13) angeordnet ist, vorzugsweise vertikal unterhalb von dem Warmlufteingang (13).

3. Rechenzentrum (1) nach einem der vorangegangenen Ansprüche, bei dem das Innere des Containers (2) von der Umgebung des Containers (2) fluidisch abgetrennt ist, so dass eine Durchmischung der im Innern des Containers (2) aufgenommenen Luft und der Umgebungsluft vermieden ist.

4. Rechenzentrum (1) nach einem der vorangegangenen Ansprüche, bei dem die Schottung (4) zumindest abschnittsweise horizontal und/oder unter einem spitzen Winkel zur Horizontalen geführt ist.

5. Rechenzentrum (1) nach einem der vorangegangenen Ansprüche, bei dem die Schottung (4) zumindest in einem horizontalen und/oder unter einem spitzen Winkel zur Horizontalen geführten Abschnitt optisch transparent ist.

6. Rechenzentrum (1) nach Anspruch 5, wobei oberhalb von dem optisch transparenten Abschnitt eine vertikal nach unten abstrahlende Lichtquelle (14) angeordnete ist.

7. Rechenzentrum (1) nach einem der vorangegangenen Ansprüche, bei dem sich der Warmgang (6) oberhalb der Schaltschrankreihe (3) über die gesamte Breite des Innern des Containers (2) und über die Schaltschrankreihe (3) hinweg erstreckt.

8. Rechenzentrum (1) nach einem der vorangegangenen Ansprüche, bei dem sich der Warmgang (6) zwischen gegenüberliegenden vertikalen Außenwänden (9) des Containers (2) erstreckt, wobei eine der Außenwände (9) die Außenwand (9) mit dem mindestens einen Durchbruch (8) ist.

9. Rechenzentrum (1) nach einem der vorangegangenen Ansprüche, bei dem der Kühlluftausgang (12) unterhalb eines horizontalen oder sich unter einem spitzen Winkel zur Horizontalen erstreckenden Abschnitts der Schottung (4) angeordnet ist.

10. Rechenzentrum (1) nach einem der vorangegangenen Ansprüche, bei dem der Kühlluftausgang (12) gegenüberliegend von einem Kühllufteingang (15) der Schaltschrankreihe (3) angeordnet ist, wobei ein Warmluftausgang (16) der Schaltschrankreihe (3) an einer in Bezug auf den Kühllufteingang (15) der Schaltschrankreihe (3) gegenüber angeordneten Seite der Schaltschrankreihe (3) angeordnet ist.

11. Rechenzentrum (1) nach einem der vorangegangenen Ansprüche, bei dem in dem Warmgang (6) oberhalb von der Schaltschrankreihe (3), vorzugsweise zwischen der Schaltschrankreihe (3) und der Decke (17) des Containers (2), eine horizontale Luftführung (18) mit mindestens einem Luftführungskanal (19) angeordnet ist, wobei der Luftführungskanal (19) vorzugsweise in den Warmlufteingang (13) des Luftinnenkreises (10) des Kühlgeräts (7) mündet.

12. Rechenzentrum (1) nach einem der vorangegangenen Ansprüche, bei dem das Kühlgerät (7) eine Freiluftkühlung aufweist, die vorzugsweise ein Wärmerohr oder eine Heatpipe aufweist.

13. Rechenzentrum (1) nach Anspruch 12, bei dem das Kühlgerät (7) zusätzlich zu der Freiluftkühlung eine Kältemaschine aufweist, wobei die Freiluftkühlung und die Kältemaschine voneinander getrennte Kältemittelkreisläufe aufweisen.

14. Rechenzentrum (1) nach Anspruch 13, bei dem unter Priorisierung der Freiluftkühlung und abhängig von einer Verlustleistung der Schaltschrankreihe sowie einer Umgebungslufttemperatur des Containers (2) die beiden Kältemittelkreisläufe angesteuert sind, eine erforderliche Kühlleistung bereitzustellen.

## Claims

1. A data center (1) having a switch cabinet row (3) which is arranged in a container (2) and which separates a cold aisle (5) from a hot aisle (6) by means of a partition (4), wherein at least one cooling device (7) is inserted into at least one aperture (8) through a vertical outer wall (9) of the container (2), which is connected to the inside of the container (2) by means of its inner air circuit (10) and which is connected to the surroundings of the container (2) by means of its outer air circuit (11) which is fluidically closed off from the inner air circuit (10), and wherein the partition (4) fluidically separates a cooling air outlet (12) of the inner air circuit (10) from a warm air inlet (13) of the inner air circuit (10).

2. The data center (1) according to claim 1, in which the cooling air outlet (12) is arranged below the warm air inlet (13), preferably vertically below the warm air inlet (13).

3. The data center (1) according to one of the preceding claims, in which the inside of the container (2) is fluidically separated from the surroundings of the container (2), so that mixing of the air received in the inside of the container (2) and the ambient air is avoided.

4. The data center (1) according to one of the preceding claims, in which the partition (4) is guided at least in sections horizontally and/or at an acute angle to the horizontal.

5. The data center (1) according to one of the preceding claims, in which the partition (4) is optically transparent at least in a section guided horizontally and/or at an acute angle to the horizontal.

6. The data center (1) according to claim 5, wherein a light source (14) radiating vertically downwards is arranged above the optically transparent section.

7. The data center (1) according to one of the preceding claims, in which the hot aisle (6) extends above the switch cabinet row (3) over the entire width of the inside of the container (2) and over the switch cabinet row (3).

8. The data center (1) according to one of the preceding claims, in which the hot aisle (6) extends between opposite vertical outer walls (9) of the container (2), wherein one of the outer walls (9) is the outer wall (9) having the at least one aperture (8).

9. The data center (1) according to one of the preceding claims, in which the cooling air outlet (12) is arranged below a section of the partition (4) extending horizontally or at an acute angle to the horizontal.

10. The data center (1) according to one of the preceding claims, in which the cooling air outlet (12) is arranged opposite a cooling air inlet (15) of the switch cabinet row (3), wherein a warm air outlet (16) of the switch cabinet row (3) is arranged on a side of the switch cabinet row (3) arranged opposite the cooling air inlet (15) of the switch cabinet row (3).

11. The data center (1) according to one of the preceding claims, in which a horizontal air guide (18) having at least one air guide channel (19) is arranged in the hot aisle (6) above the switch cabinet row (3), preferably between the switch cabinet row (3) and the roof (17) of the container (2), wherein the air guide channel (19) preferably opens into the warm air inlet (13) of the inner air circuit (10) of the cooling device (7).

12. The data center (1) according to one of the preceding claims, in which the cooling device (7) has a free cooling, which preferably has a heat pipe.

13. The data center (1) according to claim 12, in which the cooling device (7) has a refrigerating machine in addition to the free cooling, wherein the free cooling and the refrigerating machine have refrigerant circuits separate from one another.

14. The data center (1) according to claim 13, in which the two refrigerant circuits are controlled to provide a required cooling power by prioritizing the free cooling and depending on a power loss of the switch cabinet row and an ambient air temperature of the container (2).

## Revendications

1. Centre de données (1) avec une rangée d'armoires électriques (3) agencée dans un conteneur (2), qui sépare un couloir froid (5) d'un couloir chaud (6) à l'aide d'une cloison (4), au moins un appareil de refroidissement (7) étant inséré dans au moins une ouverture (8) pratiquée dans une paroi extérieure verticale (9) du conteneur (2), qui est relié par son circuit d'air interne (10) à l'intérieur du conteneur (2) et qui est relié par son circuit d'air externe (11), isolé de manière fluidique du circuit d'air interne (10), à l'environnement du conteneur (2), et la cloison (4) séparant fluidiquement une sortie d'air froid (12) du circuit d'air interne (10) d'une entrée d'air chaud (13) du circuit d'air interne (10).

2. Centre de données (1) selon la revendication 1, dans lequel la sortie d'air froid (12) est agencée en dessous de l'entrée d'air chaud (13), de préférence verticalement en dessous de l'entrée d'air chaud (13).

3. Centre de données (1) selon l'une des revendications précédentes, dans lequel l'intérieur du conteneur (2) est séparé de l'environnement du conteneur (2) de manière à empêcher le mélange de l'air pris à l'intérieur du conteneur (2) et de l'air ambiant.

4. Centre de données (1) selon l'une des revendications précédentes, dans lequel la cloison (4) est au moins en partie horizontale et/ou forme un angle aigu avec l'horizontale.

5. Centre de données (1) selon l'une des revendications précédentes, dans lequel la cloison (4) est optiquement transparente au moins dans une partie horizontale et/ou forme un angle aigu avec l'horizontale.

6. Centre de données (1) selon la revendication 5, dans lequel une source lumineuse (14) rayonnant verticalement vers le bas est agencée au-dessus de la partie optiquement transparente.

7. Centre de données (1) selon l'une des revendications précédentes, dans lequel le couloir chaud (6) s'étend au-dessus de la rangée d'armoires électriques (3) sur toute la largeur de l'intérieur du conteneur (2) et au-dessus de la rangée d'armoires électriques (3).

8. Centre de données (1) selon l'une des revendications précédentes, dans lequel le couloir chaud (6) s'étend entre des parois extérieures verticales opposées (9) du conteneur (2), l'une des parois extérieures (9) étant la paroi extérieure (9) qui comporte au moins une ouverture (8).

9. Centre de données (1) selon l'une des revendications précédentes, dans lequel la sortie d'air froid (12) est agencée en dessous d'une partie horizontale ou forme un angle aigu par rapport à l'horizontale de la cloison (4).

10. Centre de données (1) selon l'une des revendications précédentes, dans lequel la sortie d'air froid (12) est agencée en face d'une entrée d'air froid (15) de la rangée d'armoires électriques (3), une sortie d'air chaud (16) de la rangée d'armoires électriques (3) étant agencée sur un côté de la rangée d'armoires électriques (3) situé à l'opposé de l'entrée d'air froid (15) de la rangée d'armoires électriques (3).

11. Centre de données (1) selon l'une des revendications précédentes, dans lequel un conduit d'air horizontal (18) avec au moins un canal de conduit d'air (19) est agencé dans le couloir chaud (6) au-dessus de la rangée d'armoires électriques (3), de préférence entre la rangée d'armoires électriques (3) et le plafond (17) du conteneur (2), le canal de conduit d'air (19) débouchant de préférence dans l'entrée d'air chaud (13) du circuit d'air interne (10) de l'appareil de refroidissement (7).

12. Centre de données (1) selon l'une des revendications précédentes, dans lequel l'appareil de refroidissement (7) comprend un refroidissement à l'air libre qui comprend de préférence un caloduc ou un tube de chaleur.

13. Centre de données (1) selon la revendication 12, dans lequel l'appareil de refroidissement (7) comprend, en plus du refroidissement à l'air libre, une machine frigorifique, le refroidissement à l'air libre et la machine frigorifique comprenant des circuits de réfrigérant séparés les uns des autres.

14. Centre de données (1) selon la revendication 13, dans lequel les deux circuits de réfrigérant sont commandés de manière à fournir la puissance frigorifique requise, en donnant la priorité au refroidissement à l'air libre et en fonction d'une puissance dissipée par la rangée d'armoires électriques et d'une température ambiante du conteneur (2).
